(19) Europäisches Patentamt
European Patent Office
Office européen des brevets

(11) **EP 2 033 318 B1**

(12) **EUROPEAN PATENT SPECIFICATION**

(45) Date of publication and mention
of the grant of the patent:
**04.07.2012 Bulletin 2012/27**

(21) Application number: **07798653.7**

(22) Date of filing: **15.06.2007**

(51) Int Cl.:
*H03L 7/187* (2006.01)    *H03L 7/093* (2006.01)
*H03L 7/099* (2006.01)    *H03L 7/10* (2006.01)
*H03L 7/107* (2006.01)

(86) International application number:
**PCT/US2007/071367**

(87) International publication number:
**WO 2007/147132 (21.12.2007 Gazette 2007/51)**

(54) **CONTINUOUS GAIN COMPENSATION AND FAST BAND SELECTION IN A MULTI-STANDARD, MULTI-FREQUENCEY SYNTHESIZER**

KONTINUIERLICHE VERSTÄRKUNGSKOMPENSATION UND SCHNELLE BANDAUSWAHL BEI EINEM MEHRFREQUENZSYNTHESIZER MIT MEHREREN STANDARDS

COMPENSATION DE GAIN CONTINUE ET SÉLECTION DE BANDE RAPIDE DANS UN SYNTHÉTISEUR MULTISTANDARD, MULTIFRÉQUENCE

(84) Designated Contracting States:
**AT BE BG CH CY CZ DE DK EE ES FI FR GB GR HU IE IS IT LI LT LU LV MC MT NL PL PT RO SE SI SK TR**

(30) Priority: **15.06.2006 US 454192**

(43) Date of publication of application:
**11.03.2009 Bulletin 2009/11**

(73) Proprietor: **TriDev Research LLC**
**Dover, DE 19904 (US)**

(72) Inventors:
• **VENUTI, Jeff**
  **Somerville, MA 02143 (US)**
• **BOHORQUEZ, Jose**
  **Arlington, MA 02474 (US)**

(74) Representative: **Small, Gary James et al**
**Carpmaels & Ransford**
**One Southampton Row**
**London WC1B 5HA (GB)**

(56) References cited:
**EP-A- 0 664 617**        **EP-A- 1 460 762**
**US-A- 5 175 729**        **US-A- 5 461 344**
**US-A- 6 114 920**        **US-A1- 2002 079 972**
**US-A1- 2004 232 999**

**Description**

BACKGROUND

Field of Invention

The present invention is directed to a wideband, low power frequency synthesizer including gain compensation and operating frequency band selection and calibration.

Discussion of Related Art

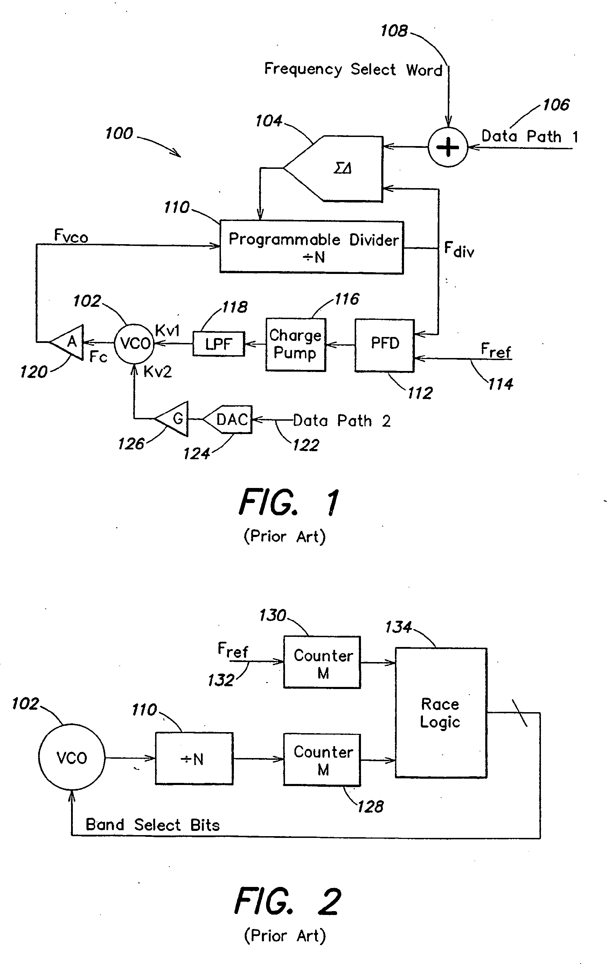

In a wireless transmitter, a typical application for a frequency synthesizer is to provide a local oscillator signal (LO) to a mixer which in turn is used to up-convert a modulated data signal to a higher, radio frequency (RF), signal that is suitable for transmission over an antenna. If, as for example with the Global System Mobile (GSM) standard, a constant-envelope modulation is used, then the output of the frequency synthesizer can be directly modulated to superimpose modulated data on the voltage controlled oscillator (VCO) output. Referring to FIG. 1, there is illustrated an example of a conventional frequency synthesizer 100 including a VCO 102 in a phase-locked loop. The phase locked loop includes a programmable divider 110, a phase detector 112 (which also receives a reference frequency on line 114), a charge pump 116 and a loop filter 118. The output of the VCO 102 is fed back into the loop via an amplifier 120, as shown in FIG. 1. One method and apparatus for directly modulating the VCO 102 at the output of the frequency synthesizer is to provide a path for data modulation through a so-called Sigma-Delta modulator 104. By summing properly formatted and clocked data (entering the sigma-delta modulator on line 106) with a constant frequency control word going into the modulator on line 108, the data signal can be superimposed on the final frequency synthesizer output.

A problem with this approach is that the data is shaped in the frequency domain by the low-pass frequency response dynamics of the phase-locked loop. If the bandwidth of the data signal is greater than the low-pass bandwidth of the loop, then the data signal will be undesirably shaped or distorted. To compensate for this distortion, the same data signal that is applied to the sigma-delta modulator on line 106 (data path 1) may also be used to modulate the voltage controlled oscillator by way of a second data path with a high-pass filter response. The superposition of data signals from both paths onto the output of the frequency synthesizer can then yield a flat response for data at the output port of the frequency synthesizer. The method and apparatus for using two data paths to modulate the frequency synthesizer output is referred to as Two-Point Modulation.

Referring to FIG. 1, data entering the frequency synthesizer on line 106, i.e., through data path one, is in digital format. Data entering the system, on line 122, i.e., through data path two, may also be in the form of a digital signal. Therefore, a digital-to-analog converter 124 may be placed in series with data path two so that an analog signal is input to the VCO 102. In addition, an amplifier 126 with a variable gain G can also be placed in the path, between the digital-to-analog converter 124 and the VCO 102, as illustrated in FIG. 1. It can be shown that in order for the overall frequency response for data modulating the frequency synthesizer output to remain flat, (i.e. undistorted), the variable gain G must meet the requirement: $G=Fref/Kv2$. Here, the value of the reference frequency Fref (input to the frequency synthesizer on line 114) is determined by the system design and is therefore a known quantity. However, the value of the gain of the auxiliary port into the VCO, Kv2 (in units of MHz/V), is a quantity that can experience variations due to changes in circuit operating conditions, for example, fluctuations in temperature and supply voltage.

In general, conventional methods for compensating for variations in the gain Kv2 in Two-Point Modulators involve digital measurements and calibration with periodic updates. However, such methods may suffer from limitations imposed by the time that a system is allowed for a calibration update, since the process is disruptive to the actual operation of the frequency synthesizer and a phase lock must be reacquired after each calibration step. One example of a method of gain compensation is given in U.S. Patent No. 5,307,071 to Arnold et al., entitled "Low noise frequency synthesizer using half integer dividers and analog gain compensation" Another example of a method of gain compensation is disclosed in U.S. Patent No. 6,700,447 to Nilsson entitled "Trimming of a two point phase modulator." These examples rely on the introduction of extraneous calibration sequences, and therefore suffer from the major disadvantage that the calibration sequences can introduce noise, or frequency spurs, into the frequency synthesizer, thereby severely degrading system performance.

Besides gain compensation, frequency calibration can be another important consideration. Conventional frequency calibration approaches have the disadvantage in that they take too long to settle to a final selection of the appropriate band, particularly if the number of bands approaches 32 or even 64 (corresponding to a 5 or 6 bit VCO band control). One example of a conventional frequency calibration method is a successive approximation method which uses a race counter, as illustrated in FIG. 2. In this example, a VCO 102 employed in a phase locked loop configuration is locked to a particular reference frequency, Fref, by dividing it with a frequency divider 110 having a division ratio N, and comparing the result to Fref (see FIG. 1). As illustrated in FIG. 2, the same VCO 102 and programmable divider 110 can be used in an open loop manner to compare the results of a counter 128 that receives the divided VCO signal to the result of an identical counter 130 that receives the reference frequency signal on line 132. Each counter 128, 130 counts pulses of the divided VCO signal and the reference frequency Fref, respectively, and the results are compared by race logic circuitry 134. The methodology is such that the first counter to complete its count is used as an indicator of which frequency is higher, either the reference frequency (Fref) or the divided VCO frequency (Fvco/N). If the divided VCO frequency (Fvco/N) is higher, it is an indication that the VCO 102 needs to be set to a lower frequency band. Accordingly, the VCO band can be set to a new value, and the count comparison is repeated. This procedure is repeated using a successive approximation algorithm for searching through the VCO bands to find the appropriate band in which the desired VCO frequency (N*Fref) can be found. Once the appropriate band has been found, the VCO 102 can be set in order for the phase-locked loop to successfully acquire a lock with the reference frequency.

In a race counter system, the size of the counter is a function of the required accuracy required for the final band decision. In turn, the required accuracy is a function of the amount of overlap between the bands. As an example, if a frequency accuracy, Faccuracy, of 500 kHz is needed, then it can be shown that the counter value, M, is governed by the equation:

$$\text{Faccuracy=Fref/(M-1)} \qquad \qquad (1)$$

Thus, for a 50 MHz reference frequency, a counter value of 105 is needed. Counting 105 cycles of a 50MHz signal takes approximately 2.1μs. Carrying out this procedure for each bit of a six bit band selection scheme would therefore require 12.6μs.

Another document in this technical field is US 5 175 729A, disclosing a frequency synthesizer according to the preamble of claim1.

SUMMARY OF INVENTION

The present invention provides a frequency synthesizer comprising
a voltage controlled oscillator (138) coupled in phase-locked loop configuration with a programmable divider (140) and a charge pump (144);
a first loop filter (146) coupled between an output of the charge pump (144) and an input of the voltage controlled oscillator (138);
a second loop filter coupled in parallel with the first loop filter between the output of the charge pump (144) and the input of the voltage controlled oscillator (138);
a first switch coupled to the first loop filter (146) and adapted to switch in and out the first loop filter; and
a second switch coupled to the second loop filter and adapted to switch in an out the second loop filter;
wherein the frequency synthesizer is configured such that selective activation of the first and second switches causes one of the first and second loop filters to be active in the phase-locked loop;
wherein the programmable divider (140) is directly coupled to an output of the voltage controlled oscillator (138);
wherein the programmable divider comprises a plurality of cascaded fractional divider blocks; and
wherein a digital control signal is applied to each of the plurality of cascaded fractional divider blocks to activate selected ones of the plurality of cascaded fractional divider blocks so as to set a divide ratio for the programmable divider (140).

Described is a method for continuous gain compensation in a Two-Point Modulation frequency synthesizer that may involve no extra calibration sequences and may take advantage of the realization that all the information necessary for continually compensating the gain of the second data path may be already present in the system. In another embodiment, there may be provided a method for VCO band calibration which can reduce the locking time in half (compared to the 12.6μs discussed above) by using predetermined initial settings for which bands should be used for which frequencies. In yet another embodiment, there may be provided a frequency synthesizer including a programmable divider with a very wide range of programmable division ratios. The programmable divider may be capable of operating at very high frequencies and at low power by interfacing directly to the VCO. In one example, a source-coupled logic approach may be used for the design of a cascaded chain of divider blocks that may allow for the use of a low power supply. These features may facilitate design of a frequency synthesizer that may be flexible (capable of synthesizing local oscillator carrier frequencies for a wide range of communication standards), efficient and fast.

Also described is a method of voltage controlled oscillator band calibration in a frequency synthesizer may comprise acts of setting a value of a band selection control signal to an initial setting based on an expected frequency band in which an operating center frequency is located, iteratively adjusting the value of the band selection control signal to search one frequency band setting above and one frequency band setting below the initial setting until a proper setting for an operating frequency band in which the operating center frequency is located is determined, and setting the value of the band selection control signal to the proper setting to tune a resonant frequency of the voltage controlled oscillator into the operating frequency band. The method may further comprise an act of fine tuning the resonant frequency of the voltage controlled oscillator to the operating center frequency. In one example, the act of setting the value of the band selection control signal may include setting a bit pattern for a digital control signal to control a plurality of switches to activate selected ones of a corresponding plurality of capacitors such that the resonant frequency of the voltage controlled oscillator is in the operating frequency band. In another example, the act of fine tuning may include adjusting a control voltage for a variable capacitor to fine tune the resonant frequency of the voltage controlled oscillator to the operating center frequency. Furthermore, the act of iteratively adjusting the value of the band selection control signal may include comparing a scaled version of the resonant frequency of the voltage controlled oscillator to a reference frequency using a race counter circuit.

Also described is a voltage controlled oscillator comprising a plurality of switchable tuning circuits that in combination provide a resonant circuit that generates a resonant frequency of the voltage controlled oscillator, and a controller adapted to provide a digital band control signal that controls switching in and out of the resonant circuit the plurality of switchable tuning circuits to select an initial resonant frequency band setting. The controller is further adapted to iteratively adjust a value of the digital band control signal to search one frequency band setting above and one frequency band setting below the initial resonant frequency band setting until a proper value of the digital band control signal is determined to select an operating frequency band for the resonant circuit that includes a desired operating center frequency of the voltage controlled oscillator. In one example, the plurality of switchable tuning circuits may comprise a plurality of switchable capacitors. In another example, the digital band control signal may include a plurality of bits and the controller may be adapted to set a bit pattern for the digital band control signal to control a plurality of switches to activate selected ones of the plurality of switchable capacitors such that the resonant frequency of the voltage controlled oscillator is in the operating frequency band. The voltage controlled oscillator may further comprising a fine tuning circuit coupled to the plurality of switchable tuning circuits and to the controller, and the controller may be further adapted to provide a fine tuning signal to the fine tuning circuit to fine tune the resonant frequency of the voltage controlled oscillator to the desired operating center frequency. In another example, the fine tuning circuit may include at least one variable capacitor, and the controller may be adapted to adjust a control voltage for the at least one variable capacitor to fine tune the resonant frequency of the voltage controlled oscillator to the desired operating center frequency.

Also described is a programmable two-point frequency synthesizer architecture may comprise a voltage controlled oscillator having a first port, a second port and an output, a programmable divider coupled to the output of the voltage controlled oscillator and adapted to receive a data signal, a phase detector having a first input coupled to an output of the programmable divider and a second input adapted to receive a reference frequency, the phase detector being adapted to produce a loop signal based on a combination of the reference frequency an a signal received from the programmable divider, a first loop filter coupled between an output of the phase detector and the first port of the voltage controlled oscillator so as to provide a phase locked loop including the voltage controlled oscillator, the programmable divider, the phase detector and the first loop filter, a variable gain amplifier having an output coupled to the second port of the voltage controlled oscillator, an input adapted to receive the data signal, and a control port, a correlation canceling circuit coupled to the control port of the variable gain amplifier and adapted to receive the data signal and the loop signal. The correlation canceling circuit may be adapted produce a control signal based on the data signal and the loop signal and to apply the control signal to the control port of the variable gain amplifier, and the control signal may be selected to continuously adjust a gain of the variable gain amplifier such that an output signal of the voltage controlled oscillator divided by the programmable divider is substantially equal to the reference frequency. In one example, the programmable two-point frequency synthesizer may further comprise a second loop filter coupled in parallel with the first loop filter between the output of the phase detector and the first port of the voltage controlled oscillator, a first switch coupled to the first loop filter and adapted to switch in and out the first loop filter, and a second switch coupled to the second loop filter and adapted to switch in an out the second loop filter, and the programmable two-point frequency synthesizer may be configured such that selective activation of the first and second switches causes one of the first and second loop filters to be active in the phase-locked loop.

A frequency synthesizer may comprise a voltage controlled oscillator coupled in phase-locked loop configuration with a programmable divider and a charge pump, a first loop filter coupled between an output of the charge pump and an input of the voltage controlled oscillator, a second loop filter coupled in parallel with the first loop filter between the output of the charge pump and the input of the voltage controlled oscillator, a first switch coupled to the first loop filter and adapted to switch in and out the first loop filter, and a second switch coupled to the second loop filter and adapted to switch in an out the second loop filter. The frequency synthesizer may be configured such that selective activation of the first and second switches causes one of the first and second loop filters to be active in the phase-locked loop. In one example, the first and second switches may be MOS switches. In another example, a value of a control voltage applied to a gate of the first switch may be selected so as to open the first switch, thereby decoupling the first loop filter from the phase locked loop. In another example, the frequency synthesizer may further comprise at least one additional loop filter coupled in parallel with the first and second loop filters, and a corresponding at least one additional switch coupled to the at least one additional loop filter and operable to connect and disconnect the at least one additional loop filter from the phase-locked loop. The first loop filter may comprise a combination of resistors and capacitors selected and configured to implement a predetermined transfer function. Furthermore, in one example, the programmable divider may be directly coupled to an output of the voltage controlled oscillator. The programmable divider may comprise a plurality of cascaded fractional divider blocks, wherein a digital control signal is applied to each of the plurality of cascaded fractional divider blocks to activate selected ones of the plurality of cascaded fractional divider blocks so as to set a divide ratio for the programmable divider.

A method of controlling an operating frequency of a frequency synthesizer comprises acts of generating a resonant frequency using a phase-locked loop that includes a first loop filter and a second loop filter, providing a selection signal that controls switching in an out of the phase-locked loop the first and second loop filters, and adjusting the selection signal to control switching of the first and second loop filters, based on the resonant frequency, such that one of the first and second loop filters is active in the phase-locked loop.

A programmable fractional-N divider comprises a plurality of fractional divider blocks coupled together in series, each one of the plurality of fractional divider blocks having a control port adapted to receive a digital control signal, wherein the digital control signal activates and deactivates selected ones of the plurality of fractional divider blocks so as to set a divide ratio for the programmable fractional-N divider. Each of the plurality of divider blocks may comprise a plurality of flip-flops coupled to digital components. In one example, the digital components may comprise at least one AND gate.

BRIEF DESCRIPTION OF THE DRAWINGS

Various embodiments and aspects of the invention are described in detail below with reference to the accompanying figures. It is to be appreciated that the accompanying drawings are not intended to be drawn to scale. In the drawings, each identical or nearly identical component that is illustrated in various figures is represented by a like numeral. For purposes of clarity, not every component may be labeled in every drawing. In the drawings:

FIG. 1 is a block diagram of a frequency synthesizer employing Two-Point Modulation;
FIG. 2 is a block diagram of a conventional race-counter band calibration circuit;
FIG. 3 is a block diagram of one example of a frequency synthesizer including Two-Point Modulation, according to an embodiment of the invention;
FIG. 4 is a diagram illustration one example of a voltage controlled oscillator implementation, according to an embodiment of the invention;
FIG. 5 is a graph illustrating an example of voltage controlled oscillator tuning bands;
FIG. 6 is a graph illustrating a shift in the VCO bands of FIG. 5 due to varying operating conditions;
FIG. 7 is a block diagram of a modified race-counter circuit according to an embodiment of the invention;
FIG. 8 is a block diagram of one example of a programmable divider architecture including a series of cascaded dividers, according to the invention;
FIG. 9 is a logic circuit diagram of one example of a digital logic implementation of one of the dividers of FIG. 8, according to another embodiment of the invention;
FIG. 10 is a circuit diagram of one example of a circuit implementation for the logic circuit shown in FIG. 9; and
FIG. 11 is a circuit diagram of one example of a frequency synthesizer including multiple switchable loop filter, according to the invention.

DETAILED DESCRIPTION

There is described, a frequency synthesizer capable of wideband operation and that may include a method of gain compensation that may not require external calibration sequences, as well as a method of fast VCO band selection. To facilitate wideband operation, embodiments of the frequency synthesizer may include switchable independent loop filters that may allow the frequency synthesizer to accommodate significant changes in bandwidth. In addition, there are disclosed methods of gain compensation and VCO band selection, as well as a fast, wideband programmable divider configuration that may be used in embodiments of frequency synthesizers according to the invention.

It is to be appreciated that this invention is not limited in its application to the details of construction and the arrangement of components set forth in the following description or illustrated in the drawings. The invention is capable of other embodiments and of being practiced or of being carried out in various ways, and the invention is not limited to the examples presented unless specifically recited in the claims. In addition, it is to be appreciated that the phraseology and terminology used herein is for the purpose of description and should not be regarded as limiting. The use of the words "including," "comprising," "having," "containing," or "involving," and variations thereof herein, is meant to encompass the items listed thereafter and equivalents thereof as well as additional items.

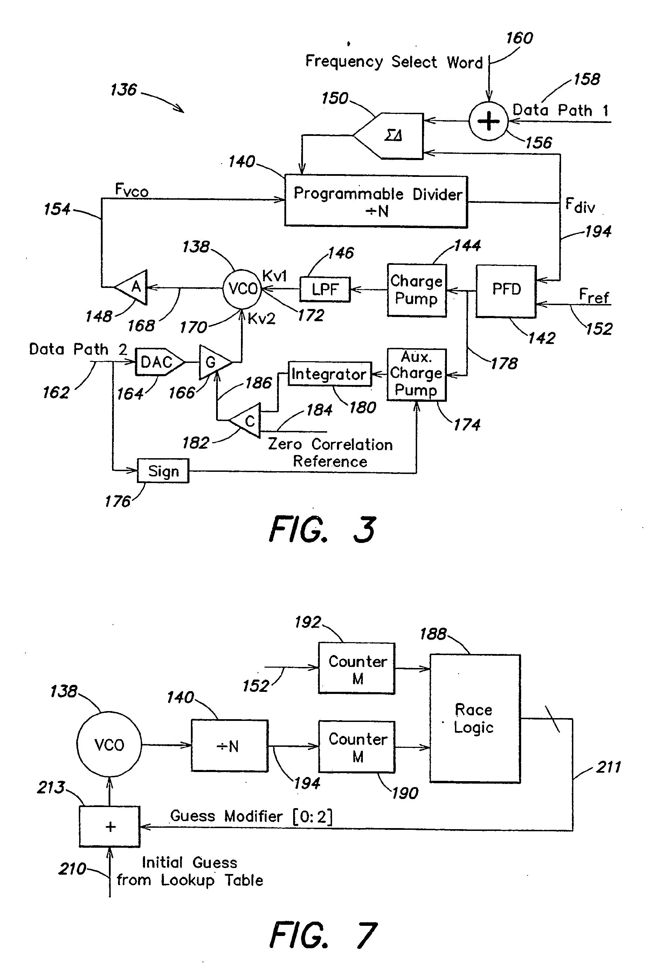

Referring to FIG. 3, there is illustrated a block diagram of one embodiment of frequency synthesizer employing Two-Point Modulation and continuous gain correction circuitry, according to one embodiment of the invention. The frequency synthesizer 136 includes a voltage controlled oscillator (VCO) 138 in phase-locked loop configuration. The loop includes a programmable fractional-N divider 140, a phase detector 142, a charge pump 144 and a loop filter 146. In addition, the output of the VCO 138 may be amplified by an amplifier 148 before being fed back to the programmable divider 140. A reference frequency is fed to the phase-locked loop on line 152.

In one embodiment, the frequency synthesizer may further include a sigma-delta modulator 150 for modulating a data signal (containing data to be transmitted) onto a carrier frequency generated by the frequency synthesizer. A carrier signal produced by the frequency synthesizer, herein referred to as Fvco on line 154, may be directly modulated by providing a path for data modulation through the Sigma-Delta modulator 150. By summing (either in a summer 156 or in the sigma-delta modulator itself) properly formatted and clocked data on line 158 (referred to as data path one) with a constant frequency control word provided on line 160, the data signal can be superimposed on the carrier signal at the frequency synthesizer output. This may have the benefit of being a relatively simple method of modulation, which may reduce the overall complexity (by reducing the number of component blocks) of, for example, a transmitter in which the frequency synthesizer may be used. Fewer components may reduce the overall power consumption of the device, which may also be desirable. The frequency control word may be supplied, for example, by a microcontroller (not shown) that may be coupled to the frequency synthesizer.

According to one embodiment, the frequency synthesizer may use Two-Point Modulation, in which the same data signal is also fed to the VCO 138 via a second data path (data path two). The digital data signal on line 162 may pass through a digital-to-analog converter 164 to be converted to an analog signal that may be fed, via a variable gain amplifier 166, to the VCO 138. As discussed above, by using two data paths, one with a low pass filter response (i.e., the path that passes through the loop filter 146 of the phase locked loop) and a second path with a high pass filter response (data path two), the superposition of the signals from both data paths onto the carrier signal generated by the frequency synthesizer can yield a flat wideband response for the modulated data on the carrier signal at the frequency synthesizer output. In order for the overall frequency response of the data modulating the carrier frequency to remain flat, (i.e. undistorted), the variable gain G of the variable gain amplifier should meet the requirement: $G=Fref/Kv2$, where $Kv2$ is the value of the gain (in units of MHz/V) of the auxiliary VCO port 170 in data path two. $Kv2$ is a quantity that may experience variations due to changes in circuit operating conditions, for example, fluctuations in temperature and supply voltage. It may therefore be desirable that the value of G continuously tracks $Kv2$ to account for any such variations.

According to one embodiment of the invention, there is provided a frequency synthesizer that may involve no extra calibration sequences and takes advantage of the realization that all the information necessary for continually adjusting the gain of data path two may be already present in the system. Under ideal system conditions, where the gain G is perfectly calibrated, introducing a data signal into both data paths, as discussed above, may result in a signal at the primary VCO control port 172 having a gain setting $Kv1$, which may be perfectly flat. If, however, there is a mismatch between the setting of the gain G, and the value of $Fref/Kv2$, there will be some residual data signal observable on the main control port 172 of the VCO 138. If the gain G is too small, the residual signal on the main control port 172 may exhibit a directly proportional correlation with the input data. Alternatively, if the gain G is too large, then the residual signal on the main control port 172 may exhibit an inversely proportional correlation with the input data. Based on this information and knowledge of the input data, a feedback control system can be developed that monitors this correlation and corrects the gain of the data path until there is zero correlation (or nearly zero correlation) between the observed signal on the main control port and the input data.

Referring to again FIG. 3, one embodiment of a frequency synthesizer according to aspects of the invention may include correlation canceling circuitry coupled to data path two. In one example, an auxiliary charge pump 174 may be used to mirror the response of the main phase locked loop. The auxiliary charge pump 174 may provide information regarding any residual signal in the main loop due to gain mismatch without directly sensing the main VCO control port 172. The sign of the input data may be sensed (by sign-sensing circuit 176) and may be used to reverse the polarity of the response of the auxiliary charge pump 174 to the signal from the phase detector 142 on line 178 which represents the residual data signal in the main loop. The output of the auxiliary charge pump 174 may be integrated, as represented in FIG. 3 by integrator 180. The direction and rate of change in the integrated signal may provide information about the correlation of the input data with the residual signal in the main loop. A correlation signal produced by integrator 180 may be compared in an error amplifier 182 with a zero correlation reference voltage, input to the error amplifier on line 184. The output of the error amplifier 182 may provide a correction voltage on line 186 to the variable gain amplifier 166 to control the gain G of data path two. In this manner, the gain G may be continually adjusted so as to maintain a flat, undistorted output signal from the VCO 138.

As an alternative, according to another embodiment, the residual data signal of the main loop may be directly sensed at the main control port 172 of the VCO 138. However, it should be noted that direct sensing of the main VCO control port could potentially be disruptive if any switch transients occur while tracking the sign of the input data. These transients, which may develop through capacitive coupling or switch charge injection, could be integrated by the loop filter 146 and undesirably affect the performance of the main loop. Therefore, in at least some embodiments, the above-described method in which no direct sensing of the main control port 172 of the VCO 138 is required may be preferable.

As discussed above, another embodiment of the invention may be directed to a method of VCO band selection/ calibration that may allow the frequency synthesizer to achieve faster locking times by reducing the time taken to select and appropriate VCO frequency band. In particular, predetermined initial settings may be used to limit the number of frequency ranges over which a search algorithm may be performed to find the desired operating frequency band, as discussed below.

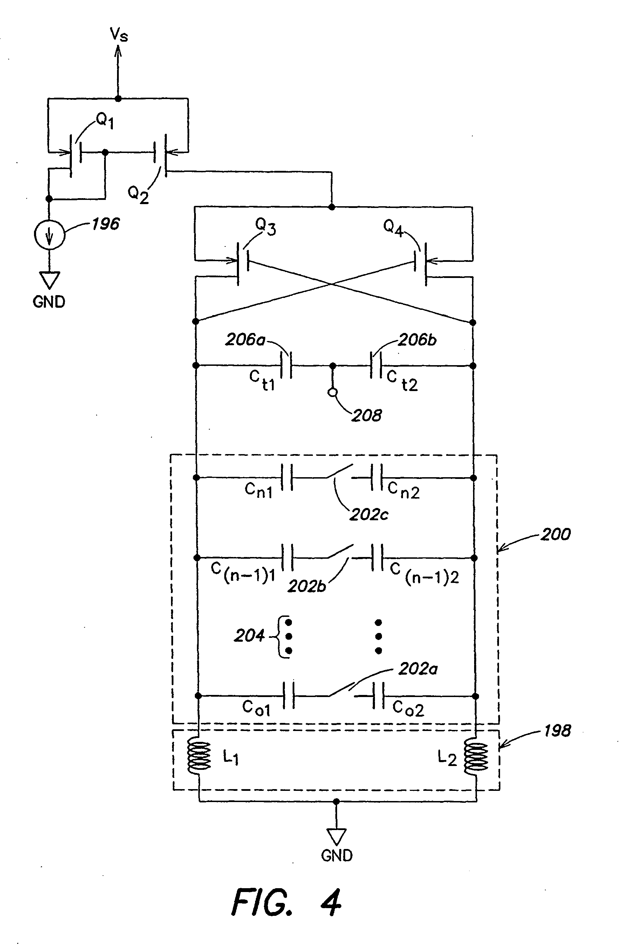

Referring to FIG. 4, there is illustrated one example of a schematic circuit implementation for the VCO 138. According to one embodiment, the VCO circuit may use cross-coupled PMOS transistors Q1 and Q2 to generate a negative resistance, and use NMOS, source-follower tail transistors Q3 and Q4 to control bias currents. The degree of control may be accomplished by a current source 196. A power supply source voltage may be supplied at terminal $V_s$. The carrier signal produced by the frequency synthesizer may generally have a known, desired operating center frequency, referred to as Fc and output from the VCO on line 168 (see FIG. 3). For example, referring again to FIG. 4, the VCO 138 may comprise a tunable capacitive element in parallel with an inductive element 198 to provide a resonating structure that generates the carrier frequency Fc. The resonant tuning circuit may comprise inductors 198 (e.g., including inductors L1 and L2) that may be augmented by a capacitor bank 200 as well as additional tuning capacitors as discussed below. In one example, the VCO resonant circuit may use fixed inductors formed by transmission lines in conjunction with fixed and variable capacitive elements. This architecture may provide an efficient implementation of a wideband tuning circuit for the VCO that may allow a tuning range of more than a gigahertz.

According to one embodiment, the inductors L1 and L2 may be implemented as bondwires that may be used to couple various circuit components to a semiconductor substrate. Each bondwire may have associated with it a certain inductance that may be dependent on the length of the bondwire, the cross-sectional area of the bondwire, and the spacing between adjacent bondwires (which affects mutual inductive coupling between the bondwires). At a given operating frequency, the inductance associated with the bondwires may be approximated by a fixed inductance, which is the inductance represented by L1 and L2 in FIG. 4. It is to be appreciated that each of L1 and L2 may be include one or more bondwires, and also that inductors 198 may include additional inductive elements as well. The use of bondwire inductors in a VCO resonant circuit may have several advantages, including, for example, providing better phase noise, lower power consumption, and wider tuning range than may conventional on-chip spiral inductors. Improved phase noise may be due to the higher quality factor (Q) of the bondwires with respect to on-chip inductors, such as spiral inductors, and extended tuning range may be due to the lower parasitic capacitance associated with bondwire inductors. In addition, conventional spiral inductors are relatively large, and using bondwires instead of such spiral inductors may allow for a smaller circuit footprint. However, it is to be appreciated that the invention does not require the use of bondwires for inductors 198, and other transmission line inductors or conventional inductors may also be used.

Referring again to FIG. 4, the capacitive element may include, for example, a bank of switchable fixed value capacitors 200 such that, by selecting which of these capacitors are active, a "band" of resonant frequencies may be selected. In one embodiment, the VCO 138 may be configured such that it has a plurality of operating frequency bands. The bank of capacitors 200 may include, for example, a plurality of MOS (metal oxide semiconductor) or MIM (metal-insulator-metal) capacitors that may be switched electronically by control signals applied to the switches 202a...202b, 202c. It is to be appreciated that any type of capacitor may be used; however, MOS and MIM capacitors are common to CMOS and other semiconductor circuits and may therefore be preferred in some embodiments. To address the tradeoffs between better circuit performance and wider microelectronic process variations, the switchable bank of capacitors 206 may be used to increase the overall tuning range of the VCO, while reducing its tuning sensitivity to abate the effects of electromagnetic (EM) coupling and further improve phase noise. This may be done by dividing the overall tuning range into frequency bands. In one example, the capacitors 200 may have relatively large capacitance values (e.g., on the order of tens of picofarads each) and a desired operating frequency band may be selected by switching in and/or out appropriate ones of the capacitors.

According to one embodiment, a six-bit switched metal on metal (MOM) capacitor array may be used for band selection. In this example, the capacitor bank 200 may include six pairs of capacitors $C_{01}$ and $C_{02}$ to $C_{n1}$ and $C_{n2}$, where (in this example) n = 6. Of course it is to be appreciated that the invention is not limited to a six-bit case, and other values of n may be used, for example, a four-bit or eight-bit design. In addition, each bit need not correspond to a pair of capacitors, but may instead control one or multiple capacitors. A digital control word, referred to herein s the VCO band-select control signal, may be issued (for example, by a microcontroller) to activate switches 202a...202b, and 202c. In one example, this control word may be a binary word that may include a bit to control each of the switches. For example, in the illustrated six-bit case, bit 0 may control switch 202a, bit 5 may control switch 202b and bit 6 may control switch 202c. The other intervening bits may control additional switches not shown in FIG 4, but represented by dots 204.

Once a frequency band has been selected, the desired center frequency Fc may be tuned within this band, for example, by controlling a variable capacitance (e.g., a varactor diode) that also forms part of the capacitive element of the resonating structure. Referring to FIG. 4, in one example, fine tuning within the selected frequency band may be achieved by controlling capacitance values of variable capacitors 206a and 206b. In one example, two accumulation mode MOS varactors $C_{t1}$ and $C_{t2}$ may be used for fine-tuning the frequency by applying a variable analog voltage (Vcontrol) through terminal 208. These varactors may be implemented, for example, as NMOS inside N-well varactors, although other designs may also be used. Embodiments of a VCO that may be used in the invention are disclosed in co-pending, commonly-owned U.S. Patent Application No. 11/202,626, entitled "PROGRAMMABLE RADIO TRANSCEIVER," filed August 11, 2005, and in co-pending, commonly-owned U.S. Patent Application entitled "PROGRAMMABLE TRANSMITTER ARCHITECTURE FOR NON-CONSTANT AND CONSTANT ENVELOPE MODULATION," filed on even date herewith.

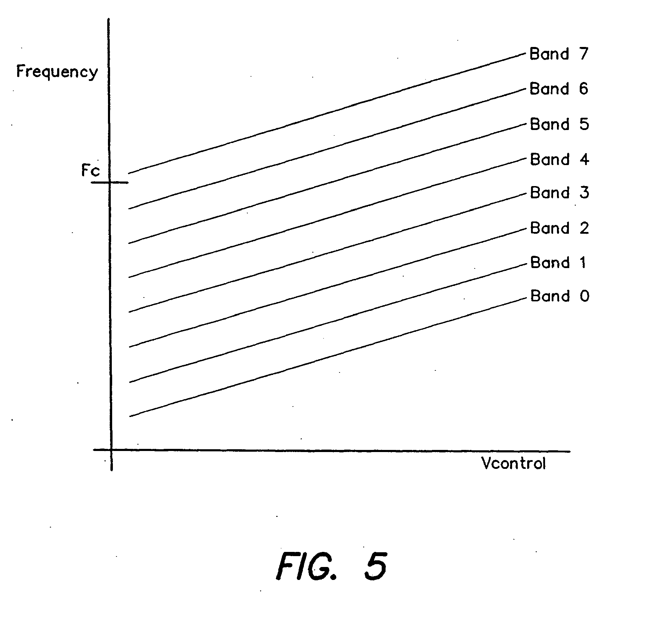

One example of the effective relationship between the bands that may be selected by controlling the bank of fixed capacitors, a control voltage that tunes the variable capacitance, and the VCO output frequency is illustrated in FIG. 5. As shown in FIG. 5, once a frequency band 0-7 has been selected by activating an appropriate bit pattern to switch in and out, ones of the bank of switchable capacitors, the value of the center frequency Fc may be tuned within that band by varying the control voltage (Vcontrol) to tune the variable capacitance. Thus, in at least one embodiment, the switched capacitors 200 may serve as a means of coarse tuning, and the variable capacitors whose capacitance can be adjusted via a variable control voltage (e.g., varactor diodes), may be used for fine tuning. It is of course to be appreciated that other resonant circuits for the VCO may also achieve the same result, namely that the VCO frequency may be tuned over and within several operating frequency bands, and the invention is not limited to the particular example given herein.

Table 1 below illustrates some examples of frequency band selection for three different VCOs that can be realized with a six bit binary pattern 0 - 63. It is to be appreciated that the frequency band values given for each VCO are exemplary only and not intended to be limiting. The actual band values for a given implementation may depend on the values of the capacitors 200, the inductance values provided by inductor 198, the reference frequency value (see, for example, FIG. 1) and other factors.

TABLE 1

| Bit Pattern | | | | | | Frequency Band | VCO 1 | | VCO 2 | | VCO 3 | |
|------|------|------|------|------|------|---------|------|------|------|------|------|------|
| Bit5 | Bit4 | Bit3 | Bit2 | Bit1 | Bit0 | | Min. Freq. | Max. Freq. | Min. Freq. | Max. Freq. | Min. Freq. | Max. Freq. |
| 0 | 0 | 0 | 0 | 0 | 0 | 0 | 1848 | 1863 | 2280 | 2299 | 4267 | 4397 |
| 0 | 0 | 0 | 1 | 1 | 1 | 7 | 1792 | 1806 | 2211 | 2226 | 3716 | 3803 |
| 0 | 0 | 1 | 1 | 1 | 1 | 15 | 1734 | 1746 | 2139 | 2153 | 3286 | 3348 |
| 0 | 1 | 0 | 1 | 1 | 1 | 23 | 1680 | 1691 | 2074 | 2087 | 2976 | 3021 |
| 0 | 1 | 1 | 1 | 1 | 1 | 31 | 1632 | 1642 | 2015 | 2026 | 2741 | 2777 |
| 1 | 0 | 1 | 1 | 1 | 1 | 39 | 1588 | 1596 | 1960 | 1971 | 2553 | 2582 |
| 1 | 0 | 1 | 1 | 1 | 1 | 47 | 1547 | 1554 | 1910 | 1920 | 2400 | 2424 |
| 1 | 1 | 0 | 1 | 1 | 1 | 55 | 1508 | 1516 | 1863 | 1872 | 2271 | 2291 |
| 1 | 1 | 1 | 1 | 1 | 1 | 63 | 1473 | 1480 | 1820 | 1828 | 2161 | 2179 |

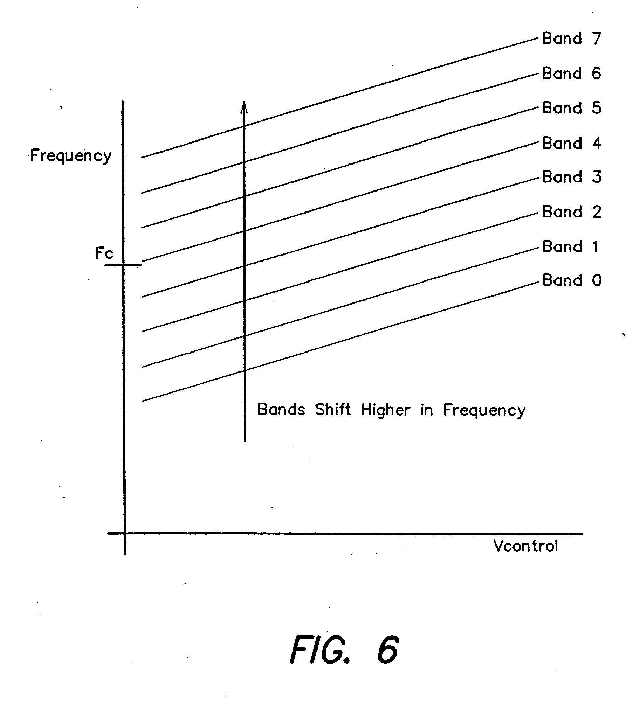

The desired operating center frequency Fc may fall in any one of the operating frequency bands of the VCO 138. In the absence of supply voltage changes, temperature fluctuations, and manufacturing process and parameter variations, one may have *a priori* knowledge as to which frequency band it would be appropriate to set the VCO to in order to maintain the desired frequency Fc. However, the aforementioned changes in operating conditions may have the undesired effect of shifting the bands to higher or lower frequencies, as illustrated in FIG. 5. As shown in FIG. 6, due to some changes in operating conditions, the VCO bands have shifted higher in frequency. As an example, whereas before Fc could be found in band 7, now Fc no longer falls within band 7. This illustrates how a manual setting of the VCO may become problematic in the presence of varying operating conditions. Consequently, in one embodiment of the invention, an intelligent method of automatic selection, or calibration, of the VCO's center frequency band may be provided so as to ensure that the desired frequency, Fc, is found within the selected band.

As discussed above, there are prior art methods of VCO calibration, such as the race-counter method. However, these methods may suffer the disadvantage that they take too long to settle to a final selection of the appropriate band, particularly if the number of bands starts approaching values of 32 or 64 (as would be the case for 5- or 6-bit VCO band control, which may be common for a multi-band frequency synthesizer). Therefore, according to aspects of the invention, there may be provided a method of VCO band calibration that may vastly reduce the settling time by using predetermined initial settings for which bands should be used for which desired center frequencies.

In some applications it may be highly desirable that the speed at which the VCO frequency band is determined be very fast. This may require very fast synthesizer locking times. An example of such an application is the GSM cellular standard for mobile handsets for which locking times may need to be as fast as 100 $\mu$s. Often, it may be very difficult to meet such a fast locking time even without any consideration of VCO band selection. If a VCO band needs to be selected before the routine of acquiring a frequency lock in the phase-locked loop can be begun, it may become even more difficult to obtain a lock quickly enough to comply with standards such as the GSM. Therefore, some embodiments of the invention are directed to a method that may reduce the amount of time needed for VCO band selection, thereby allowing maximum time for the frequency synthesizer to obtain a lock. In particular, methods according to embodiments of the invention may allow minimal overhead time between switching synthesizer frequencies from one desired operating frequency to another.

According to one embodiment of the invention, there may be provided a method for VCO band calibration in which an intelligent initial band selection may be used to set the VCO band very close to the appropriate band of operation. A modified binary search algorithm may then be used to search bands above or below the initial setting in such a manner that only a few iterations of a count and compare cycle may need to be repeated. In at least one embodiment, these methods may reduce the lock time in half compared to the 12.6 $\mu$s taken by some prior art designs, as discussed above.

Referring to FIG. 7, there is illustrated a block diagram of one embodiment of a modified race-counter band calibration circuit according to an embodiment of the invention. In the illustrated example, a so-called race logic circuit 188 may receive inputs from two M counters 190, 192. The first counter 190 may receive as its input the frequency Fdiv from the programmable divider 140 (in the synthesizer's phase locked loop) on line 194. The reference frequency may be applied to the second counter 192 on line 152. Depending on the intended polarity of the circuit, if a signal is received from the second counter 192 before the first counter 190, then the race logic circuit 188 may change the band select bits (applied to activate the switches 202 in FIG. 4) to operate the VCO at a higher frequency. Conversely, if a signal is received from the first counter 190 before the second counter 192, then the race logic circuit 188 may change the band select bits to operate the VCO at a lower frequency setting. In this manner, the appropriate band of operation desired for the VCO output (divided by N) may iteratively converge to the reference frequency.

As discussed above, in a conventional race-counter design, the comparison of the counters may be repeated for a number of times equivalent to the number of band select bits. The size, M, of the counters may be a function of the accuracy desired for the final band decision and the reference frequency (Fref) selected for the synthesizer. In addition, the desired accuracy may be a function of the amount of overlap between the frequency bands of the VCO. For example, a GSM synthesizer using a reference frequency of 52MHz and a VCO having 6 bands to select from, an accuracy (Faccuracy) of 500 kHz would be needed. As mentioned above, since, an example value of Fref = 50 MHz would require a counter value of 105. Counting 105 cycles of a 50 MHz signal takes about 2.1 $\mu$s, and to do this for each bit of a six bit band selection therefore takes 12.16 $\mu$s. Generally, the calibration time may then be calculated from the equation:

$$Tcal = [(1/Faccuracy) + (1/Fref)] * VCO\_bands. \qquad (2)$$

where Faccuracy=Fref/(M-1) and M is the size of the counters.

According to one embodiment, a method for VCO band calibration can reduce this calibration time in half by using predetermined initial settings for which bands should be used for which frequencies. An intelligent initial selection setting may set the VCO band initially very close to an appropriate band of operation. Referring again to FIG. 7, the frequency synthesizer may include, or may be coupled to, a memory device (not shown) that includes a look-up table and supplies the estimated value for bits of the VCO-band select control signal on line 210. This estimate may be based on, for example, the a priori knowledge of which band the desired center frequency Fc should fall, absent variations in operating conditions. The estimate is used to set initial values for the bits of the VCO band-select control signal. Then, the race-counter circuitry may be used to adjust the VCO band-select control signal to the appropriate band in which Fc is in fact located (taking into account varying operating conditions, as discussed above in reference to FIG. 6). Specifically, in one example, a search algorithm can be used that searches the two adjacent bands above or below the initial setting. This may provide a far more confined search space. As shown in FIG. 7, the output from the race logic circuitry 188 may be supplied on line 211 to a summer 213 where it may be combined with the estimate signal supplied from the look-up table, and then fed to the VCO 138 to select a frequency band for the VCO. In such a manner, only three iterations of the count-and-compare cycle may be performed, even though the VCO may have eight bands (for 6-bit control). In this particular case the time required to find the appropriate frequency band, Tcal, may be given by:

$$Tcal=[(1/Faccuracy)+(1/Fref)]*3 \qquad\qquad (3)$$

where 3 is fewer than the number of VCO bands. As can be seen from the above equation, this method may significantly reduce the time taken to locate the appropriate frequency band, thereby allowing the frequency synthesizer to lock to a desired center frequency more quickly.

In a frequency synthesizer designed to accommodate a number of different communication standards across many different frequency bands, the VCO 138 desirably should be capable of producing a large range of output frequencies. Likewise, the fractional-N divider 140 desirably should be capable of a large range of division ratios in order to divide the VCO frequency (Fvco) to match the reference frequency (Fref) for frequency calibration. Also, in some embodiments of a multi-standard system, the VCO 138 may be likely to oscillate at very high frequencies, and the programmable divider 140 may therefore need to interface to the VCO at these very high frequencies.

Some prior art solutions avoid the need to design a divider capable of operating at the same frequency as the VCO by placing a so-called prescaler, having a division value M, in front of the programmable divider to reduce the frequency at which the programmable divider needs to operate. One example of such a design is disclosed in a paper by Ahmed, et al. ("CMOS VCO-prescaler cell-based design for RF PLL frequency synthesizers," 2000 IEEE Proceedings ISCAS, Geneva, Volume 2, May 2000, pp. 737 - 740).

A drawback of this solution is that quantization noise that may be produced by the sigma-delta modulator in the frequency synthesizer (see FIG.1) may be multiplied by the value of the prescaler, M in the process of performing fractional-N division of the VCO output signal. In addition, the minimum value for frequency division in the fractional-N divider, Nmin, now may be limited by the product of M*Nmin. It often may be likely that for a multi-standard wideband system architecture, the minimum division ratio may need to be lower than what can be achieved using this method. An example of a conventional architecture that attempt to address this problem of limited programmable division ratios by using a cascaded arrangement of dual modulus 2/3 dividers, is disclosed in paper by C.S. Vaucher et al. ("A Family of Low-Power Truly Modular Programmable Dividers in Standard 0.35-um CMOS Technology," IEEE J. Solid-State Circuits, vol. 35, pp. 1039-1045, July 2000),

However, this example, though capable of some moderately high speeds, is not optimal for low power operation at very high speed due to the use of many stacked MOS (metal oxide semiconductor) devices which require a high power supply voltage.

According to the invention, there is provided a programmable divider with a very wide range of programmable division ratios. In addition, the programmable divider may be capable of operating at very high frequencies and at low power by interfacing directly to the VCO. In one embodiment, this may be achieved through the use of an alternative source-coupled logic approach for the design of cascaded divider blocks that allows for the use of a low voltage power supply, for example, by using a reduced number of stacked MOS devices.

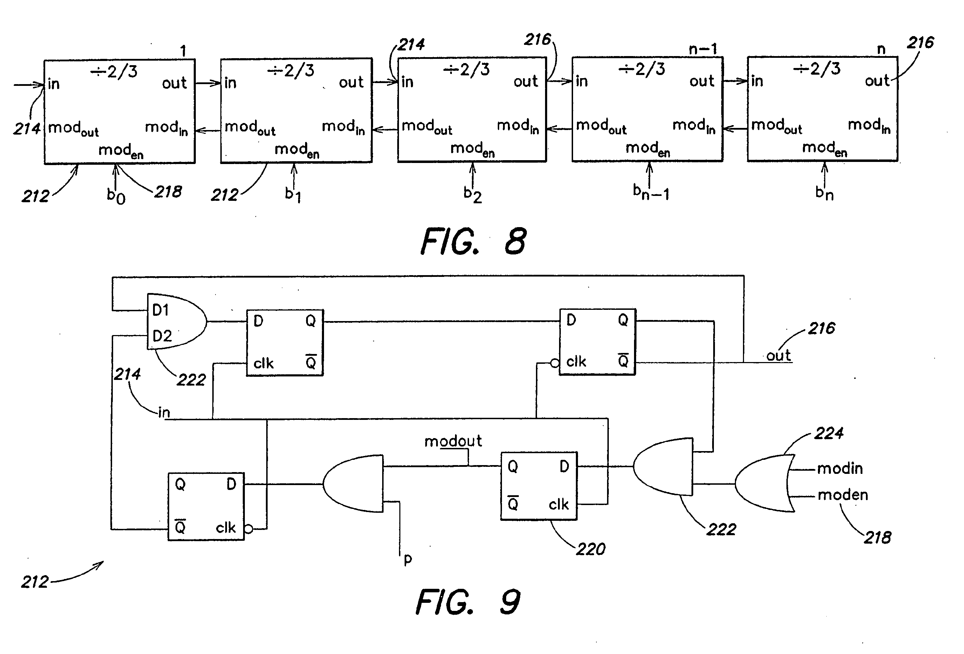

Referring to FIG. 8, there is illustrated one example of an implementation for the programmable fractional-N divider including a series of cascaded fractional divider blocks 1 through n. Each fractional divider block 212 may have, for example, a divide ratio of 2/3 and may include an input 214 to receive the VCO output signal Fvco, for the first divider in the chain, and the divided signal from the preceding divider for all other dividers 212 in the chain. The outputs 216 of each divider, (except the last one in the chain), are coupled to the input of the next divider in the chain such that the signal can be divided successively by 2/3. The output of the last divider block in the chain may provide the frequency Fdiv on line 194 (see FIG. 3). In one embodiment, a control signal that comprises a number of bits n equal to the number of dividers in the chain may be applied to the dividers to control a divide ratio of the overall fractional-N divider 140. As illustrated in FIG. 8, a bit of the control signal may be applied to a mode-enable input 218 of each divider 212. Based on the setting of the binary inputs b0, b1, ...,bn, which may be supplied, for example, by a microcontroller, the overall divide ratio may be set.

Referring to FIG. 9, there is illustrated one example of a logic implementation of each divider block 212 in FIG. 8. In the illustrated example, the divider blocks 212 may be implemented using four D-latch flip-flops (220), three AND gates (222), and an OR gate (224) as seen in FIG. 9. The signal p indicates a permanent logic 1 state. This design may be advantageous in that it may be very simple and allow great flexibility (because of the combination of divide ratios supplied by the binary bit pattern b0...bn) while involving few components and therefore allowing low power operation. In addition, in contrast to the design disclosed in the paper by Vaucher et. al, referenced above, this embodiment does not require the use of many stacked MOS devices, which are typically high-power devices.

For maximum reconfigurability in light of changes in VCO frequency and reference frequency Fref, a programmable divider 140, implemented, for example, as discussed above, may accommodate a wide range of divide values. For example, for a VCO output of 900 MHz and a reference frequency of 104 MHz, the division value is 8.65. In a fractional-N synthesizer, such a divide ratio has two parts: the integer part 8 and the fractional part 0.65. Since a frequency divider circuit may only be capable of dividing by an integer amounts, an averaging technique may be used to achieve an approximation of the fractional divide ratio over a long term. For example, the frequency divider may divider the signal it receives by an integer value every clock cycle. Considering, for example, 100 clock cycles, then to achieve a long-term approximation of a divide ratio of 8.65, a division by 8 may be performed 35 times (i.e., for 35 clock cycles) and a division by 9 may be performed for 65 clock cycles. This may result in an effective average divide ratio over the 100 clock cycles of 8.65, as shown by the equation:

$$\frac{(8*35)+(9*65)}{100} = 8.65 \qquad (4)$$

In a sigma-delta modulated fractional-N synthesizer, such as used in at least some embodiments of the invention, the sigma-delta modulator may control effecting the desired division ratio. For example, the sigma-delta modulator may add a number from the set {-4, -3, -2, -1, 0, 1, 2, 3, 4} to the nominal integer divide ratio on a cycle-to-cycle basis, such that the average effective divide ratio over many clock cycles is approximates a desired fractional divide ratio. As another example, consider a VCO output of 2.5 GHz and a reference frequency of 13 MHz. In this example, the division ratio would be 192.308. Therefore, the nominal integer divide ratio may be 192, and the fractional portion may be approximated by changing increasing or decreasing the integer value 192 by up to plus or minus 4 each clock cycle, such that the long-term average is approximately 192.308. A programmable divider capable of accommodating both of these examples may easily and simply be implemented using the above-described design with an appropriate number of bits n.

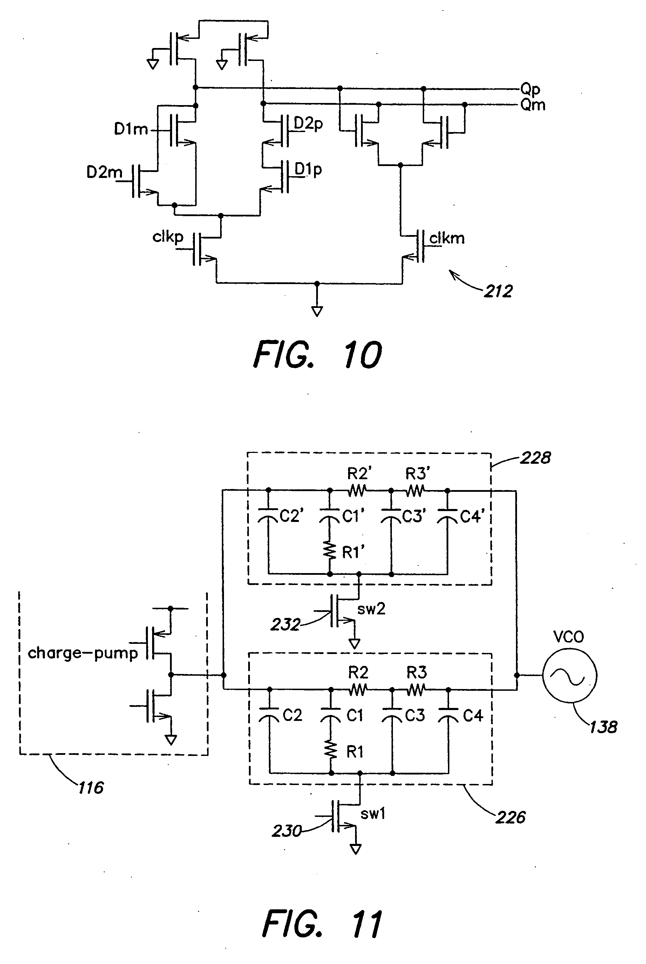

One embodiment of a circuit implementation of one of the fractional divider blocks 212 is illustrated in FIG. 10. In this embodiment, a so-called source-coupled CMOS divider gate circuit is shown that is a low power transistor level implementation of the logic circuit depicted in FIG. 9. To a first order, at a given input frequency, the power consumption in the divider block 212 may be proportional to the average DC current drawn by the circuit shown in FIG. 10, multiplied by the supply voltage. By designing the circuits as described above, implemented in such a way as to be able to accommodate a lower supply voltage, the power saved may be directly proportional to the amount by which the power supply voltage may be lowered. Because the above-described circuits are simple and use relatively few components and few MOS devices, they may scaled to a smaller node size and thus may require a lower power supply voltage for operation. For example, if the circuits are scaled down in node size such that, instead of a 1.5V power supply, a 1.2V power supply can be accommodated, then this design will have realized a 20% reduction in power consumption for the programmable divider, which is often one of the most power consuming blocks in the frequency synthesizer.

According to the invention, the frequency synthesizer is be configured to accommodate significant changes in bandwidth by including two independent loop filters. As discussed above, if the bandwidth of the data signal to be modulated onto the carrier generated by the frequency synthesizer is larger than the bandwidth of the loop filter, some signal distortion can occur. This can, at least in part, be compensated for by the use of Two-Point Modulation as discussed above. In addition, if two or more loop filters are provided, with a mechanism for switching between them depending on an operating frequency range of the VCO, even wider, non-distorted frequency synthesizer bandwidth may be achieved. Referring to FIG. 11, there is illustrated a portion of a frequency synthesizer according to an embodiment of the invention, including two independent loop filters 226 and 228 coupled between the charge pump 116 and the voltage controlled oscillator 138 (see FIG. 3). Each loop filter 226, 228 may comprise capacitor and resistor combinations. The first loop filter 226 may include capacitors C1, C2, C3 and C4 in combination with resistors R1, R2 and R3, and the second loop filter may comprise capacitors C1', C2', C3' and C4' in combination with resistors R1', R2' and R3', as shown. The values and configuration of the resistors and capacitors for each loop filter may be selected so as to implement any desired transfer function, including low pass or high pass transfer functions, and transfer functions having different bandwidths, center frequencies or cut-off frequencies. It is to be appreciated that the loop filters are not limited to the exact resistor and capacitor implementations illustrated, and also the frequency synthesizer is also not limited to two loop filters; the design is extendable to a number of parallel loop filters greater than two.

Referring to FIG. 11, each loop filter 226, 228 may be coupled to a corresponding MOS switch 230, 232, respectively. The two MOS switches 230, 232 may receive control signals applied to their respective gates. Depending on the voltage levels of the applied control signals, a connection may be established between the respective loop filter structure and ground. For example, when MOS switch 230 or MOS switch 232 is open, that is, in a so-called high impedance state, the entire corresponding loop filter may behave as if a high impedance exists. As a result, that loop filter may be effectively disconnected between the charge pump 116 and the VCO 138. However, as soon as one of the MOS switches 230 or 232 turns into a low impedance state (as a result of receiving the appropriate gate bias voltage), a direct connection to ground may be established and the respective loop filter may become active between the charge pump 116 and the VCO 138. In this manner, an appropriate loop filter (or combination of loop filters) may be selected by applying an appropriate control voltage (which may be controlled, for example, by a microcontroller). As discussed above, switching between multiple loop filters may facilitate accommodation of significant changes in the bandwidth of the frequency synthesizer.

In summary, aspects and embodiments of the invention are directed to a frequency synthesizer, and elements thereof, that may be particularly well-suited to use in a multi-band, multi-standard transmitter or radio transceiver. In particular, the frequency synthesizer may allow wideband operation by accommodating multiple switchable loop filters and a method of fact VCO band calibration to accommodate many different operating frequency bands, and may include a programmable divider designed to allow the use of reduced power supply voltage. In addition, the frequency synthesizer may allow continuous gain compensation, without directly sensing the VCO output and therefore without disrupting VCO operation.

**Claims**

1. A frequency synthesizer comprising
   a voltage controlled oscillator (138) coupled in phase-locked loop configuration with a programmable divider (140) and a charge pump (144);
   a first loop filter (228) coupled between an output of the charge pump (144) and an input of the voltage controlled oscillator (138);
   a second loop filter (226) coupled in parallel with the first loop filter between the output of the charge pump (144) and the input of the voltage controlled oscillator (138);
   a first switch (230) coupled to the first loop filter (228) and adapted to switch in and out the first loop filter; and
   a second switch (232) coupled to the second loop filter (226) and adapted to switch in an out the second loop filter;
   wherein the frequency synthesizer is configured such that selective activation of the first and second switches causes one of the first and second loop filters to be active in the phase-locked loop;
   wherein the programmable divider (140) is directly coupled to an output of the voltage controlled oscillator (138);
   **characterised in that**
   the programmable divider comprises a plurality of cascaded fractional divider blocks (212); and
   wherein a digital control signal is applied to each of the plurality of cascaded fractional divider blocks (212) to activate selected ones of the plurality of cascaded fractional divider blocks so as to set a divide ratio for the programmable divider (140).

2. The frequency synthesizer as claimed in claim 1, wherein the first and second switches are MOS switches.

3. The frequency synthesizer as claimed in claim 2, wherein a value of a control voltage applied to a gate of the first switch is selected so as to open the first switch, thereby decoupling the first loop filter from the phase locked loop.

4. The frequency synthesizer as claimed in claim 1, further comprising at least one additional loop filter coupled in parallel with the first (146) and second loop filters; and a corresponding at least one additional switch coupled to the at least one additional loop filter and operable to connect and disconnect the at least one additional loop filter from the phase-locked loop.

5. The frequency synthesizer as claimed in claim 1, wherein the first loop filter comprises a combination of resistors and capacitors selected and configured to implement a predetermined transfer function.

**Patentansprüche**

1. Frequenzsynthesizer, der Folgendes umfasst:

   einen spannungsgesteuerten Oszillator (138), der in einer Phasenregelkreiskonfiguration mit einem programmierbaren Teiler (140) und einer Ladungspumpe (144) gekoppelt ist;
   einen ersten Schleifenfilter (228), der zwischen einen Ausgang der Ladungspumpe (144) und einen Eingang des spannungsgesteuerten Oszillators (138) gekoppelt ist;
   einen zweiten Schleifenfilter (226), der parallel zu dem ersten Schleifenfilter zwischen dem Ausgang der Ladungspumpe (144) und dem Eingang des spannungsgesteuerten Oszillators (138) gekoppelt ist;
   einen ersten Schalter (230), der an den ersten Schleifenfilter (228) gekoppelt und ausgelegt ist zum Hinein- und Herausschalten des ersten Schleifenfilters; und
   einen zweiten Schalter (232), der an den zweiten Schleifenfilter (226) gekoppelt und ausgelegt ist zum Hinein- und Herausschalten des zweiten Schleifenfilters; und

wobei der Frequenzsynthesizer derart konfiguriert ist, dass eine selektive Aktivierung des ersten und zweiten Schalters bewirkt, dass der erste oder der zweite Schleifenfilter in dem Phasenregelkreis aktiv ist;

wobei der programmierbare Teiler (140) direkt an einen Ausgang des spannungsgesteuerten Oszillators (138) gekoppelt ist;

**dadurch gekennzeichnet, dass** der programmierbare Teiler mehrere kaskadierte fraktionale Teilerblöcke (212) umfasst; und

wobei ein digitales Steuersignal an jeden der mehreren kaskadierten fraktionalen Teilerblöcke (212) angelegt wird, um ausgewählte einzelne der mehreren kaskadierten fraktionalen Teilerblöcke zu aktivieren, um ein Teilungsverhältnis für den programmierbaren Teiler (140) einzustellen.

2. Frequenzsynthesizer nach Anspruch 1, wobei der erste und zweite Schalter MOS-Schalter sind.

3. Frequenzsynthesizer nach Anspruch 2, wobei ein Wert einer an eine Gateelektrode des ersten Schalters angelegten Steuerspannung so gewählt ist, dass der erste Schalter geöffnet wird, wodurch der erste Schleifenfilter von dem Phasenregelkreis entkoppelt wird.

4. Frequenzsynthesizer nach Anspruch 1, weiterhin umfassend mindestens einen zusätzlichen Schleifenfilter, der parallel zu dem ersten (146) und zweiten Schleifenfilter gekoppelt ist; und einen entsprechenden mindestens einen zusätzlichen Schalter, der an den mindestens einen zusätzlichen Schleifenfilter gekoppelt ist und betätigt werden kann, den mindestens einen zusätzlichen Schleifenfilter mit dem Phasenregelkreis zu verbinden und ihn davon zu trennen.

5. Frequenzsynthesizer nach Anspruch 1, wobei der erste Schleifenfilter eine Kombination aus Widerständen und Kondensatoren umfasst, die gewählt und konfiguriert sind, eine vorbestimmte Transferfunktion zu implementieren.

**Revendications**

1. Synthétiseur de fréquence comprenant

un oscillateur commandé en tension (138) relié dans une configuration de boucle à verrouillage de phase à un diviseur programmable (140) et à une pompe à charge (144),

un premier filtre de boucle (228), relié entre une sortie de la pompe à charge (144) et une entrée de l'oscillateur commandé en tension (138),

un deuxième filtre de boucle (226), relié en parallèle avec le premier filtre de boucle entre la sortie de la pompe à charge (144) et l'entrée de l'oscillateur commandé en tension (138),

un premier interrupteur (230), relié au premier filtre de boucle (228) et conçu pour mettre en et hors service le premier filtre de boucle, et

un deuxième interrupteur (232), relié au deuxième filtre de boucle (226) et conçu pour mettre en et hors service le deuxième filtre de boucle,

dans lequel le synthétiseur de fréquence est configuré de telle sorte que l'activation sélective des premier et deuxième filtres de boucle rende actif l'un des premier et deuxième filtres de boucle dans la boucle à verrouillage de phase, dans lequel le diviseur programmable (140) est directement relié à une sortie de l'oscillateur commandé en tension (138), **caractérisé en ce que** le diviseur programmable comprend une pluralité de blocs (212) de diviseurs fractionnaires en série, et

dans lequel un signal de commande numérique est appliqué à chacun de la pluralité de blocs (212) de diviseurs fractionnaires en série afin d'activer certains sélectionnés de la pluralité de blocs de diviseurs fractionnaires en série de façon à établir un rapport de division pour le diviseur programmable (140).

2. Synthétiseur de fréquence selon la revendication 1, dans lequel les premier et deuxième interrupteurs sont des interrupteurs MOS.

3. Synthétiseur de fréquence selon la revendication 2, dans lequel une valeur de tension de commande, appliquée à la grille du premier interrupteur est sélectionnée de façon à ouvrir le premier interrupteur, ce qui découple ainsi le premier filtre de boucle de la boucle à verrouillage de phase.

4. Synthétiseur de fréquence selon la revendication 1, comprenant en outre au moins un filtre de boucle supplémentaire relié en parallèle aux premier (146) et deuxième filtres de boucle et au moins un interrupteur supplémentaire correspondant relié au premier filtre de boucle supplémentaire ou plus et pouvant être actionné pour connecter et déconnecter le ou les filtres de boucle supplémentaire de la boucle à verrouillage de phase.

5. Synthétiseur de fréquence selon la revendication 1, dans lequel le premier filtre de boucle comprend une combinaison de résistances et de condensateurs sélectionnés et configurés pour mettre en oeuvre une fonction de transfert prédéfinie.

FIG. 1

(Prior Art)

FIG. 2

(Prior Art)

FIG. 3

FIG. 7

FIG. 4

17

FIG. 5

FIG. 6

FIG. 8

FIG. 9

FIG. 10

FIG. 11

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 5307071 A, Arnold
- US 6700447 B, Nilsson
- US 5175729 A
- US 20262605 A

**Non-patent literature cited in the description**

- **AHMED et al.** CMOS VCO-prescaler cell-based design for RF PLL frequency synthesizers. *2000 IEEE Proceedings ISCAS, Geneva,* May 2000, vol. 2, 737-740
- **C.S. VAUCHER et al.** A Family of Low-Power Truly Modular Programmable Dividers in Standard 0.35-um CMOS Technology. *IEEE J. Solid-State Circuits,* July 2000, vol. 35, 1039-1045